# EUROPÄISCHE PATENTSCHRIFT

(11) **EP 1 606 836 B1**
(45) Veröffentlichungstag und Bekanntmachung des Hinweises auf die Patenterteilung: **31.12.2008**
(21) Anmeldenummer: 03788848.4
(22) Anmeldetag: 04.12.2003
(51) Int. Cl.: H01L 21/68

(54) **GREIFER UND BETRIEBSVERFAHREN**
GRIPPER AND METHOD FOR OPERATING THE SAME
ELEMENT DE PREHENSION ET PROCEDE D'UTILISATION

(30) Priorität: 19.12.2002 DE 10259836
(43) Veröffentlichungstag der Anmeldung: 21.12.2005
(73) Patentinhaber: ICOS VISION SYSTEMS N.V., 3001 Heverlee (BE)
(72) Erfinder: GERHARD, Detlef, 81829 München (DE); LECHNER, Johannes, 80798 München (DE); RENNER, Martin, 82008 Unterhaching (DE)
(74) Vertreter: Quintelier, Claude
(86) Internationale Anmeldenummer: PCT/DE2003/003987
(87) Internationale Veröffentlichungsnummer: WO 2004/056678

(56) Entgegenhaltungen:
- EP-A- 1 233 442
- WO-A-99/62107
- DE-A- 4 304 301
- US-A- 4 904 012
- US-A1- 2003 133 776
- US-B1- 6 336 787

## Beschreibung

Die Erfindung betrifft einen Greifer zur Handhabung von Rahmen, sogenannten Frames, in der sogenannten Backend-Fertigung von Chips. An dieser Stelle werden fertig prozessierte Wafer auf ringförmige Rahmen gelegt, zur Vereinzelung gesägt und anschliessend mit einem Gehäuse versehen, das in der Regel aus Kunststoff besteht. Zur Handhabung der Rahmen, die mit oder ohne Wafer transportiert werden müssen, sind entsprechende Greifer notwendig. Der Greifer ist mit mindestens zwei annähernd parallel ausgerichteten, gegenseitig beabstandeten Fingern ausgerüstet. Der Greifer enthält weiter Unterdruckleitungen, die an der oberen Oberttäche der Finger des Greifers in Form von mehreren Unterdrucköffungen enden, so dass sie den ringformigen Rahmen teilweise unterstützen.

Ein derartiger Greifer und derartiger Rahmen sind aus DOS 43 04 301 bekannt.

Es ist weiterhin bekannt dass die Rahmen aus flachen, runden Kunststoffrahmen bestehen.

Dabei ist ein Rahmen in der Regel ringförmig ausgebildet und weist eine Folienüberspannung auf, so dass der innere meist kreisförmige Bereich in der Aufsicht von der Folie abgedeckt wird. Auf diese Folie wird ein prozessierter Wafer aufgeklebt. Nach dem Sägeprozess, wenn sämtliche einzelnen Chips, die auf einem Wafer enthalten sind, vereinzelt sind, ist das gesamte Gebilde bestehend aus Rahmen, Folie und darauf aufgeklebter Vielzahl von Chips sehr elastisch. Die relativ schweren Halbleiterelemente sorgen oft für eine wesentliche Verformung der Folie, so dass diese nach unter durchhängt. Für den Transport der Rahmen werden sogenannte Rahmenkassetten verwendet, die bis zu 25 Rahmen aufnehmen. Die Breite der Kassetten ist auf den Durchmesser der Rahmen angepasst, wobei die,Kassetten waagerechte übereinander liegende Schlitze aufweisen, um eine Mehrzahl von Rahmen aufzunehmen.

Um in den sogenannten Preassembly-Bereich die Rahmen mit Folie und Wafer handhaben zu können, werden in der Regel Roboter mit einem angepassten Greifer eingesetzt. Dieser Greifer be- und entlädt die Kassetten und führt die Rahmen mit Folie und Wafer verschiedenen Prozessierungsstationen zu bzw. holt diese von dort ab, um sie wieder in Kassetten abzulegen.

Das Entnehmen von Rahmen oder das Beladen der Kassetten mit diesen Rahmen ist der komplizierteste Vorgang eines solchen Transportvorgangs. Der Hintergrund verschiedener Probleme ist insbesondere die Biegsamkeit der Rahmen und der enge Schlitzabstand in den Kassetten, in denen die Rahmen jeweils benachbart übereinander lagern. Beides führt in der Regel zu sporadischen Fehlern und jeweils zum Anlagenstillstand.

Bekannt sind verschiedene Varianten von Greifern, die als Zangengreifer ausgeführt sind. Das Problem bei dieser Technik besteht darin, die Ausmasse des Greifers mit den dicht in eine Kassette gelagerten Rahmen zu kombinieren. Ein derartiger Zangengreifer ist zum Anfahren eines Schlitzes in einer Kassette nicht geeignet, da die beiden für einen Zangengreifer notwendigen, zusammenwirkenden Systeme nur schwer in eine gefüllte Kassette einzuführen sind. Der Zangengreifer wird sporadisch immer wieder zu Zusammenstössen zwischen Rahmen und Kassette führen. Weiterhin ist zu berücksichtigen, dass die auf die Rahmen gespannte Folie durch die Beladung mit einem Wafer stark nach unten durchhängt.

Der Erfindung liegt die Aufgabe zügrunde, einen Greifer und einen Rahmen wie auch ein Betriebsverfahren dafür bereitzustellen, womit ringförmige Rahmen mit einer Folienbespannung zum Transport von Wafem zuverlässig an mit übereinander liegenden Schlitzen versehenen Kassetten be und entladen werden können. Insbesondere soll die Handhabung von mit Folie bespannten Rahmen verbessert werden, so dass ein zuverlässiger Kontakt zwischen Greifer und mit Folien bespanntem Rahmen sichergestellt ist.

Die Lösung dieser Aufgabe geschieht durchs die jeweiligen Merkmalskombinationen der Ansprüche 1 bzw. 8.

Durch die Unterdrucköffnungen mit erhöhtem Austritt wird eine Fixierung der Folie bei gleichzeitigem Unterstützen des Rahmens ermöglicht.

Vorteilhafte Ausgestalfungen sind den Unteransprüchen zu entnehmen.

Das Wesentliche der Erfindung besteht darin, dass der Greifer lediglich eine Stützfläche aufweist, so dass er unter einen Rahmen mit Folie zwischen zwei übereinanderliegenden solchen Elementen, die in einer Kassette in zwei benachbarten Schlit-zen gelagert sind, einfahren kann. Dazu weist der Greifer Finger auf, die den Rahmen unterstützen und auch Teilbereiche der Folie, insbesondere den Außenbereich der Folie. Unterstützen der Folie bedeutet in diesem Fall, dass die Folie in dem Bereich unterstützt wird, in dem sie frei zugänglich ist, womit die Teile der Folie, die sich mit dem Rahmen zur Verklebung überschneiden, nicht betrachtet werden.

In den Bereichen des Greifers bzw. der Finger, die in der Aufsicht unterhalb der Folie zum Liegen kommen, sind sogenannte Unterdrucköffnungen am Greifer positioniert, mit denen die Folie punktuell angesaugt werden kann. Somit kann ein Rahmen mit Folie und eventuell, darauf befindlichem Wafer vom Greifer mechanisch unterstützt werden und gleich zeitig durch die Mehrzahl von Unterdrucköffnungen im Zusammenwirken mit der Folie fixiert werden.

Eine vorteilhafte Ausgestaltung der Erfindung sieht vor, dass die Unterdrucköffnungen in dem Außenbereich an der Folie positioniert werden, so dass eine gleichzeitige Unterstützung des Rahmens durch die Finger gewährleistet ist.

Für die Belange der unterschiedlichen Prozessierungsstationen sollte der Rahmen von vorneherein relativ zum Greifer genau ausgerichtet sein, beispielsweise durch Justierstifte, die entweder mit entsprechenden Aussparungen am Rahmen korrespondieren oder in Folge des passend gewählten Abstandes am kreisförmigen Außenrand des Rahmens eine mittige Ausrichtung bewirkten. Aus diesem Grund wird über Justierstifte, die am Greifer vorhanden sind und die mit Aussparungen am Rahmen korrespondieren, eine Vorausrichtung vorgenommen. Diese wird optimiert, indem in Bestückungsrichtung der Rahmen relativ zur Kassette an der Hinterseite der Kassette ein Anschlag vorgesehen ist, an den in Zusammenwirken mit den Justierstiften der Rahmen angedrückt wird, so dass eine zuverlässige laterale Ausrichtung zwischen Rahmen und Greifer möglich ist. Im Betrieb eines Greifer 9 entsprechend der Anmeldung können somit Rahmen in einer dicht bestückten Kassette problemlos aufgenommen und relativ zum Greifer durch Unterdruckfixierung im ausgerichteten Zustand fixiert werden.

Im Folgenden wird anhand von schematischen, die Erfindung nicht einschränkenden Figuren ein Ausführungsbeispiel beschrieben:
- Fig. 1: zeigt einen Greifer 1 mit Rahmen 2 und Folie 3 sowie Justierstifte 4 und einen Anschlag 7;
- Fig. 2: zeit die Frontansicht einer Kassette 9 mit quer liegenden Schlitzen 10 zur waagerechten, übereinander angeordneten Lagerung von Rahmen 2.

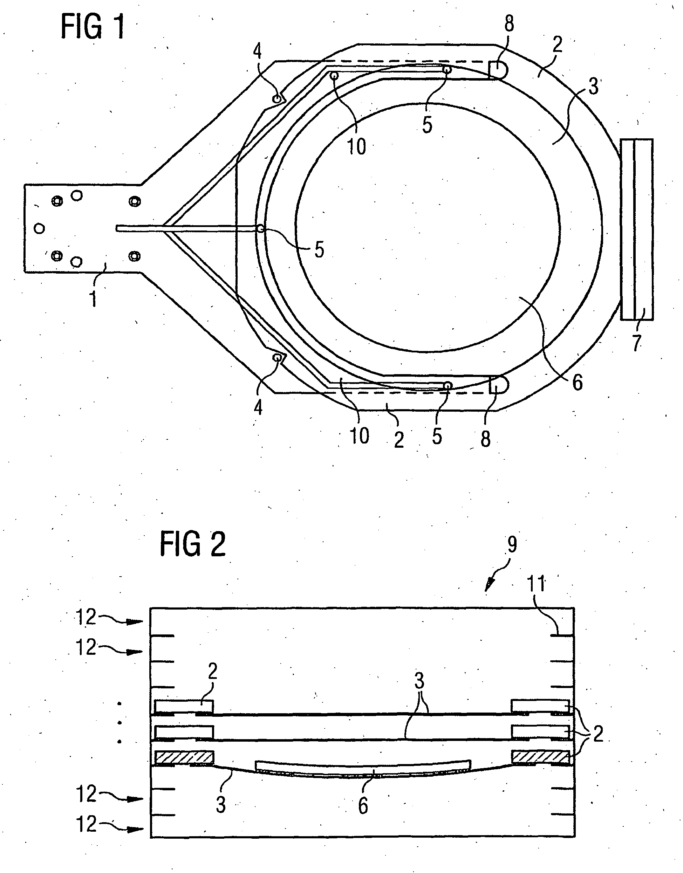

In der Fig. 1 ist ein Ausführungsbeispiel für einen erfindungsgemäßen Greifer 1 dargestellt. Dieser besitzt in diesem Fall zwei Finger 10 zur Aufnahme des Rahmens. 2. Die Unterdrucköffnungen 5, mittels derer die Folie 3 ansaugbar ist, sind im Außenbereich der Folie 3 angeordnet, d. h. in der Nähe des äußeren Randes der Folie benachbart zum inneren Rand des ringförmigen Rahmens 2. Die Unterdrucköffnungen 5 weisen eine nach oben zeigende Öffnung mit geringfügiger über die obere Oberfläche des Rahmens 1 hinausgehender Überhöhung auf, so dass sie gesichert in Kontakt mit der Folie 3 stehen. Die mit den abgeflachten Fingerspitzen 8 versehenen Finger 10 greifen in Teilbereichen jeweils unter den Rahmen 2 und die Folie 3. Die Ausbildung der Fingerspitzen 8 dient zum besseren Einfädeln zwischen den verschiedenen Rahmen 2 in einer Kassette 9.

Die Folie 3, die auf dem ringförmigen Rahmen 2 aufgespannt ist, trägt meist einen in der Größe unterschiedlichen Wafer 6, der eine Vielzahl von fertig prozessierten Chips aufweist, die in einem Sägeprozess auf der Folie gehalten werden soll.

Der Rahmen 2, der auch als Frame bezeichnet wird, soll für den Transport mit einem Greifer 1, der auch als Paddle bezeichnet wird, relativ zu diesem exakt ausgerichtet sein, um das Positionierungsverfahren in einer Prozessierungsstation zu vereinfachen. Hierzu sind zweckmäßiger Weise Aussparungen am Rahmen 2 vorgesehen, in die am Greifer 1 befestigte Justierstifte 4 beim Einfahren des Greifers 1 in die Kassette 9 eingreifen und den Wafer an einen Anschlag 7 andrücken. Durch das Zusammenwirken der Justierstifte mit den Aussparungen und der am Rahmen dargestellten geraden Außenkonturen mit dem Anschlag 7 wird diese Ausrichtung des Rahmens relativ zum Greifer bewirkt. Im Anschluss an die Ausrichtung wird über die Unterdrucköffnungen 5 Unterdruck angelegt, womit die Folie 3 und der Rahmen 2 relativ zum Greifer 1 arretiert sind.

Die Erhöhungen an den Unterdrucköffnungen 5 sind vorzugsweise oben abgerundet, um Beschädigungen an der Folie zu vermeiden. Bei den Justierstiften 4 handelt es sich um kleine, senkrecht stehende Rollen, die in die Kerben des Frames eintauchen. An einer Position einer Unterdrucköffnung 5 befindet sich vorzugsweise eine Öffnung, wobei jedoch jede andere Konfiguration mit mehreren Öffnungen an einem Fixierpunkt möglich ist.

Während des Betriebs wird zur Entnahme das Einfahren des Greifers in die Kassette 9, die anschließende Ausrichtung, Fixierung und Entnahme des Rahmens 2 aus der Kassette 9 analog zur Bestückung ablaufen, jedoch in umgedrehter Reihenfolge, wobei der Ausrichtevorgang bei der Beladung entfallen kann.

In der Fig. 2 ist die Frontansicht einer Kassette 9 dargestellt, die waagerecht liegende Schlitze 12 aufweist. Die Schlitze sind jeweils durch die Stützen 11 festgelegt, die einen Rahmen 2 lediglich an den Außenbereichen tragen. Dargestellt sind Folien 3 ohne Beladung und mit einem aufgeklebten Wafer 6 im unten dargestellten Fall. Das Gewicht des Wafers 6 führt zu einer Durchbiegung bzw. einem Durchhängen der Folie 3. Dies ist insbesondere dann der Fall, wenn der Wafer 6 bereits gesägt ist, so dass ein relativ instabiles Gebilde aus Rahmen 2, Folie 3 und Wafer 6 bzw. einzelnen Chips vorliegt. Die Finger 10 des Greifers fahren, um eine Beschädigung der Folie 3 und des Wafers 6 zu verhindern, in dem Bereich unter den Rahmen 2, in dem der Übergang zwischen dem Rahmen-Innenrand und Folie 3 liegt.

## Patentansprüche

1. Kombination eines Greifers (1) und eines ringförmigen Rahmens (2), wobei der Greifer mit mindestens zwei annähernd parallel ausgerichteten, gegenseitig beabstandeten Fingern (10) ausgerüstet ist, und am Greifer ausgebildeten Unterdruckleitungen, die an der oberen Oberfläche der Finger des Greifers in Form von mehreren Unterdrucköffnungen (5) enden, so dass sie den ringförmigen Rahmen (2) teilweise unterstützen, **dadurch gekennzeichnet dass** der Rahmen mit einer Folie (3) bespannt ist, und dass die an der oberen Oberfläche des Greifers angebrachte Unterdrucköffungen (5) mit erhöhtem Austritt enden, so dass der ringförmige, mit Folie bespannte Rahmen teilweise unterstützbar ist, wobei die Unterdrucköffnungen derart positioniert sind, dass die Folie punktuell ansaugbar ist.

2. Kombination nach Anspruch 1, **dadurch gekennzeichnet dass** die Finger des Greifers derart ausgestattet sind dass sie die Folie im Aussenbereich unterstützen.

3. Kombination nach Anspruch 2, **dadurch gekennzeichnet dass** die Unterdrucköffmüngen mit dem Außenbereich der Folie korrespondieren.

4. Kombination nach einem der Ansprüche 1 bis 3, **dadurch gekennzeichnet dass** Justierstifte (4) am Greifer angebracht sind, die mit Aussparungen am Rahmen (2) zur gegenseitigen Ausrichtung korrespondieren.

5. Kombination nach einem der Ansprüche. 1 bis 4. **dadurch gekennzeichnet dass** Folie und Rahmen einander zumindest teilweise überschneiden in einem Bereich wo die Folie frei zugänglich ist.

6. Kombination nach einem der Ansprüche 1 bis 5, **dadurch gekennzeichnet dass** die Finger mit nach vorne abgeflachten Fingerspitzen (8) ausgebildet sind.

7. Greifer wie er als Teil einer Kombination in den Ansprüchen 1 bis 6 definiert ist.

8. Verfahren zum Betrieb einer Kombination eines Greifers und eines Rahmens entsprechend einem der Ansprüche 2 bis 6, bestehend aus folgenden Schritten :
• der Greifer (1) fährt zur Aufnahme eines waagerecht gelagerten und mit Folie (3) bespannten Rahmens(2)unter diesen, so dass in der Aufsicht die Finger (10) teilweise sowohl mit dem Rahmen (2) als auch mit der Folie (3) zur Deckung kommen;
• der Greifer (1) wird angehoben bis an diesen dargestellte unter der Folie (3) positionierte, erhöhte Unterdrucköffnungen (5) mit der Folie 3 in Kontakt stehen und der Rahmen (2) auf dem Greifer (1) aufliegt;
• zum Festhalten des Rahmens Ober die Folie (3) wird Unterdruck an den Unterdrucköffnungen (5) angelegt, sobald diese in Kontakt zur Folie stehen oder spätestens bis der Hebevorgang abgeschlossen ist.

9. Verfahren nach Anspruch 8, bei dem die Kontaktpunkte der Unterdrucköffnungen (5) im Aussenbereich der Folie (3) positioniert sind.

10. Verfahren nach einem der Ansprüche 8 oder 9, bei dem externe Anschläge zur Ausrichtung des Rahmens (2) relativ zum Greifer (1) verwendet werden.

11. Verfahren nach einem der Ansprühe 8 bis 10, bei dem Transport-oder Lagerkassetten (9) mit Rahmen (2) be- oder entladen werden.

12. Verfahren nach Anspruch 11, bei dem der Greifers (1) zum Be- und Entladen von Kassetten (9) mittig zwischen Stützen (11- von in der Kassette (0) ausgebildeten Schlitzen (12) fährt, wobei die bereiche des Rahmens (2) sich in der Aufsicht mit den Stützen (11) überschneiden und der Greifer (1) sich in der Aufsicht mit Teilbereichen des Rahmens (2) und mit Teilen des Aussenbereichs der Folie (3) überschneidet.

## Claims

1. A combination of a gripper (1) and an annular frame (2), wherein the gripper is provided with at least two fingers (10) which are aligned substantially parallel to one another and are arranged at a distance from one another, and wherein on the gripper there are provided vacuum lines, which end at the upper surface of the fingers of the gripper, in the form of a plurality of vacuum openings (5), in such a manner that they partially support the annular frame (2), **characterised in that** the frame (2) is covered with a film and that the vacuum openings (5), applied at the upper surface of the gripper, end with a raised outlet in such a manner that the annular frame covered with the film can be partially supported, wherein the vacuum openings are positioned in such a manner that the film can be punctually sucked.

2. The combination as claimed in claim 1, **characterised in that** the fingers of the gripper are arranged in such a manner that they support the film at the outer region.

3. The combination as claimed in claim 2, **characterised in that** the vacuum openings correspond to the outer region of the film.

4. The combination as claimed in any one of the claims 1 to 3, **characterised in that** adjustment pins (4) are applied on the gripper, which pins correspond to cutouts on the frame (2) for the purpose of mutual alignment.

5. The combination as claimed in any one of the claims 1 to 4, **characterised in that** the film and the frame overlap each other at least partially in a section where the film is freely accessible.

6. The combination as claimed in any one of the claims 1 to 5, **characterised in that** the fingers are provided with finger ends which are flattened toward the front.

7. Gripper as defined as a part of the combination according to the claims 1 to 6.

8. A method for operating a combination of a gripper and a frame according to one of the claims 2 to 6, consisting of the following steps :
• the gripper (1) travels under a frame for picking up the frame (2) which is horizontally positioned and covered with a film (3), in such a manner that, in a plan view, the fingers (10) are at least partially covered by the frame (2) as well as by the film (3);
• the gripper (1) is lifted up until raised vacuum outlets (5), which are applied on the gripper and positioned below the film (3), come into contact with the film and the frame (2) rests on the gripper;
• a vacuum pressure being applied at the vacuum openings (5) for fixing the frame over the film (3) as soon as the vacuum openings are in contact with the film or at latest by the time the lifting operation is complete.

9. The method as claimed in claim 8, in which the contact points of the vacuum openings (5) are positioned in the outer region of the film (3).

10. The method as claimed in claim 8 or 9, in which external stops are used to align the frame (2) relative to the gripper (1).

11. The method as claimed in any one of the claims 8 to 10, in which transport or storage cassettes (9) are loaded or unloaded with the frame (2).

12. The method as claimed in claim 11, in which the gripper (1), in order to load and unload cassettes (9), travels centrally between supports (11) of slots (12) formed in the cassette (10), wherein the regions of the frame (2) overlap with the supports in plan view and the gripper (1) overlaps in plan view with partial regions of the frame (2) and with parts of the outer region of the film (3).

## Revendications

1. Combinaison d'un élément de préhension (1) et d'un cadre de forme annulaire (2), l'élément de préhension étant équipé d'au moins deux doigts (10) orientés de manière approximativement parallèle, espacés l'un de l'autre, et de conduits de dépression configurés sur l'élément de préhension qui se terminent au niveau de la surface supérieure des doigts de l'élément de préhension sous la forme de plusieurs ouvertures de dépression (5) de sorte qu'elles supportent en partie le cadre de forme annulaire (2), **caractérisée en ce que** le cadre est couvert d'un film, et **en ce que** les ouvertures de dépression (5) appliquées sur la surface supérieure de l'élément de préhension se terminent par une sortie surélevée de sorte que le cadre de forme annulaire, recouvert du film, peut être en partie supporté, les ouvertures de dépression étant positionnées de telle manière que le film peut être ponctuellement aspiré.

2. Combinaison selon la revendication 1, **caractérisée en ce que** les doigts de l'élément de préhension, sont configurés de telle manière qu'ils supportent le film dans la région extérieure.

3. Combinaison selon la revendication 2, **caractérisée en ce que** les ouvertures de dépression correspondent à la région extérieure du film.

4. Combinaison selon l'une quelconque des revendications 1 à 3, **caractérisée en ce que** des broches d'ajustement (4) sont appliquées sur l'élément de préhension, lesquelles correspondent à des évidements sur le cadre (2) pour un alignement mutuel.

5. Combinaison selon l'une quelconque des revendications 1 à 4, **caractérisée en ce que** le film et le cadre se chevauchent au moins en partie dans une région où le film est librement accessible.

6. Combinaison selon l'une quelconque des revendications 1 à 5, **caractérisée en ce que** les doigts sont réalisés avec des bouts de doigt (8) aplatis vers l'avant.

7. Elément de préhension tel qu'il est défni comme partie de la combinaison selon les revendications 1 à 6.

8. Procédé d'utilisation d'une combinaison d'un élément de préhension et d'un cadre selon l'une quelconque des revendications 1 à 6, comprenant les étapes suivantes:
- l'élément de préhension (1) se déplace pour prendre un cadre (2) monté horizontalement et couvert d'un film (3) de sorte que, vu du dessus, les doigts (10) sont en partie recouverts aussi bien par le cadre (2) que par le film (3),
- l'élément de préhension (1) est soulevé jusqu'à ce que des ouvertures de dépression (5) surélevées, appliquées sur celui-ci et positionnées en dessous du film (3) soient en contact avec le film (3) et que le cadre (2) repose sur l'élément de préhension (1),
- pour maintenir le cadre sur le film (3), une dépression est appliquée aux ouvertures de dépression (5) dès que celles-ci sont en contact avec le film ou au plus tard jusqu'à ce que l'opération de levage soit terminée.

9. Procédé selon la revendication 8, dans lequel les points de contact des ouvertures de dépression (5) sont positionnés dans la région extérieure du film.

10. Procédé selon l'une quelconque des revendications 8 ou 9, dans lequel des butées extérieures sont utilisées pour aligner le cadre (2) par rapport à l'élément de préhension (1).

11. Procédé selon l'une quelconque des revendications 8 à 10, dans lequel des cassettes de transport ou de stockage (9) sont chargées ou déchargées avec le cadre (2).

12. Procédé selon la revendication 11, dans lequel l'élément de préhension (1) se déplace, pour charger et décharger des cassettes (9), au centre entre des supports (11) de fentes (12) formées dans la cassette (10), les régions du cadre (2) chevauchant, dans la vue de dessus, les supports (11) et l'élément de préhension (1) chevauchant; dans la vue de dessus, des régions partielles du cadre (2) et des parties de la région extérieure du film (3).
